# EUROPEAN PATENT APPLICATION

(11) **EP 1 835 522 A2**
(43) Date of publication of application: **19.09.2007**
(21) Application number: 07251033.2
(22) Date of filing: 13.03.2007
(51) Int. Cl.: H01J 17/49, H01J 19/40

(54) **Plasma display apparatus and method of manufacturing the same**

(30) Priority: 13.03.2006 KR 20060023102
(71) Applicant: LG Electronics Inc., Seoul 150-721 (KR)
(72) Inventor: Cha, Hongrae, Seoul (KR)
(74) Representative: Howson, Richard G.B.

(57) **Abstract**

A plasma display apparatus and a method of manufacturing the same are disclosed. The plasma display apparatus includes a plasma display panel (100), an electromagnetic interference (EMI) shielding layer (130) positioned on the plasma display panel (110), and a filter (200) positioned on the EMI shielding layer. The filter includes an adhesive layer (230) positioned on the EMI shielding layer and a base film layer (210) positioned on the adhesive layer.

## Description

This invention relates to a display apparatus, and more particularly, to a plasma display apparatus and a method of manufacturing the same.

Amongst display apparatuses, a plasma display apparatus comprises a plasma display panel and a driver for driving the plasma display panel.

The plasma display panel has a structure in which barrier ribs formed between a front panel and a rear panel form a unit discharge cell or discharge cells. Each discharge cell is filled with an inert gas containing a main discharge gas such as neon (Ne), helium (He) or a mixture of Ne and He, and a small amount of xenon (Xe).

The plurality of discharge cells form one pixel. For example, a red (R) discharge cell, a green (G) discharge cell, and a blue (B) discharge cell form one pixel.

When the plasma display panel is discharged by a high frequency voltage, the inert gas generates vacuum ultraviolet rays, which thereby cause phosphors formed between the barrier ribs to emit light, thus displaying an image. Since the plasma display panel can be manufactured to be thin and light, it has attracted attention as a next generation display device.

Since the related art plasma display apparatus uses a high voltage and a high frequency in a driving process, electromagnetic waves emitted from a front glass of a plasma display panel are much more than electronic waves emitted from a cathode ray tube (CRT) or a liquid crystal display (LCD).

The plasma display panel emits near infrared rays induced from an inert gas such as Ne, Xe. The wavelength of the near infrared rays is very close to the wavelength of a remote controller of electric home appliances. Therefore, it is likely to cause the malfunction of the electric home appliances. Further, since the front glass of the plasma display panel reflected external light in the same way as the CRT or the LCD, and the like, the glare or a reduction in contrast was caused.

Accordingly, a glass filter or a film filter having a predetermined function was positioned on the front glass of the plasma display panel to solve the above-described problems.

However, in the related art plasma display apparatus, a film filter separately manufactured is adhered to the front glass of the plasma display panel. The separate manufacture of the film filter is costly, and a process for adhering the separately manufactured film filter to the panel is required. After the adhering process, a process for fully transferring an electromagnetic interference (EMI) shielding layer formed in the film filter on the front panel and a process for fully exposing the EMI shielding layer of a ground area for electrical connection with a bus bar are simultaneously performed. In other words, complex and precise processes are required, thereby increasing the manufacturing cost and reducing the yield.

According to one aspect of this invention, there is provided a plasma display apparatus comprises a plasma display panel, an electromagnetic interference (EMI) shielding layer positioned on the plasma display panel, and a filter positioned on the EMI shielding layer, the filter including an adhesive layer positioned on the EMI shielding layer and a base film layer positioned on the adhesive layer.

In another aspect, a plasma display apparatus comprises a plasma display panel, an electromagnetic interference (EMI) shielding layer positioned on the plasma display panel, and a resin layer positioned on the EMI shielding layer.

In still another aspect, a method of manufacturing a plasma display apparatus comprises forming an electromagnetic interference (EMI) shielding layer on a plasma display panel, and forming a resin layer on the EMI shielding layer.

In one embodiment, a plasma display apparatus comprises a plasma display panel, an electromagnetic interference (EMI) shielding layer positioned on the plasma display panel, and a filter positioned on the EMI shielding layer, the filter including an adhesive layer positioned on the EMI shielding layer and a base film layer positioned on the adhesive layer.

The EMI shielding layer may include a mesh type or a conductive type.

The filter may be formed in an area except a ground portion of the EMI shielding layer.

The adhesive layer may comprise at least one of a near infrared ray blocking material, a neon wavelength blocking material, or a selective light absorbing material.

The filter may further comprise a non-reflective layer positioned on the base film layer.

In another embodiment, a plasma display apparatus comprises a plasma display panel, an electromagnetic interference (EMI) shielding layer positioned on the plasma display panel, and a resin layer positioned on the EMI shielding layer.

The plasma display apparatus may further comprise a non-reflective layer positioned on the resin layer.

The EMI shielding layer may include a mesh type or a conductive type. Part or all of the EMI shielding layer may be a mesh-type shielding layer. Part or all of the EMI shielding layer may be a conductive-type shielding layer.

The resin layer may include a thermosetting resin layer.

The resin layer may be formed in an area except a ground portion of the EMI shielding layer.

The resin layer may comprise at least one of a near infrared ray blocking material, a neon wavelength blocking material, or a selective light absorbing material.

A method of manufacturing a plasma display apparatus comprises forming an electromagnetic interference (EMI) shielding layer on a plasma display panel, and forming a resin layer on the EMI shielding layer.

The method may further comprise forming a non-reflective layer on the resin layer.

Forming the resin layer may comprise applying a resin paste including at least one of a near infrared ray blocking material, a neon wavelength blocking material, or a selective light absorbing material to an area except a ground portion of the EMI shielding layer, and hardening the resin paste.

Applying the resin paste may comprise masking an area corresponding to the ground portion of the EMI shielding layer.

The accompany drawings, which are included to provide a further understanding of embodiments of the invention and are incorporated on and constitute a part of this specification, illustrate embodiments of the invention and together with the description serve to explain the principles of the invention.

FIG. 1 illustrates a plasma display apparatus according to one embodiment;

FIGs. 2a to 2d are views for sequentially illustrating processes for manufacturing a front filter of the plasma display apparatus according to one embodiment;

FIG. 3 illustrates a plasma display apparatus according to another embodiment; and

FIGs. 4a to 4d are views for sequentially illustrating processes for manufacturing a front filter of the plasma display apparatus according to another embodiment.

Hereinafter, exemplary embodiments of the present invention will be described in detail with reference to the attached drawings.

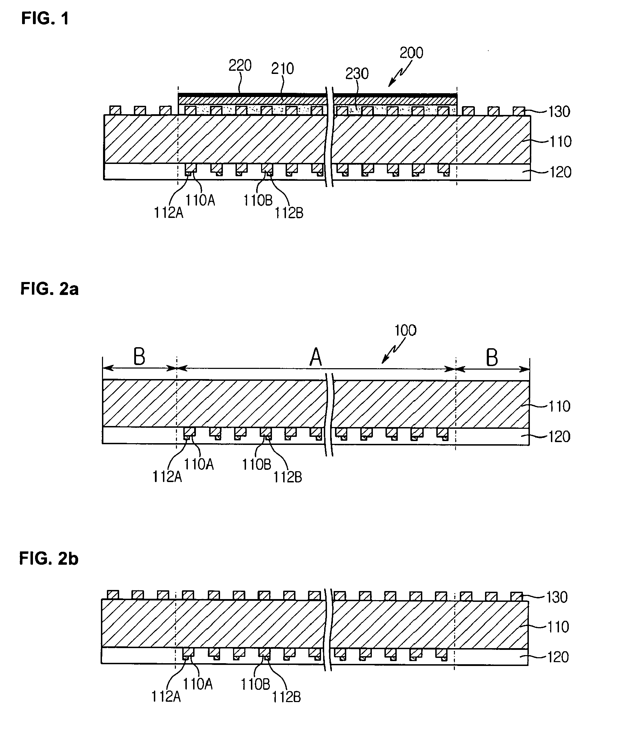

FIG. 1 illustrates a plasma display apparatus according to one embodiment.

As illustrated in FIG. 1, the plasma display apparatus according to one embodiment includes a front panel 100 (refer to FIG. 2a) of a plasma display panel, an electromagnetic interference (EMI) shielding layer 130, and a filter 200. The filter 200 includes a base film layer 210, a non-reflective layer 220, and an adhesive layer 230.

The EMI shielding layer 130 blocks the emission of electromagnetic waves generated by driving the plasma display apparatus to the outside of the plasma display apparatus through a display surface of the plasma display apparatus.

Further, the EMI shielding layer 130 is formed in a mesh type. The mesh type EMI shielding layer 130 is manufactured by forming a metal layer with conductivity in a mesh pattern, and has a ground portion at its end for grounding the metal layer of the mesh pattern.

The base film layer 210 may use a film of a normally transparent material such as polyethyleneterpthalate (PET) or tricetylcellulose (TAC).

Examples of the non-reflective layer 220 include an anti-reflection layer for blocking the emission of ultraviolet rays to the outside of the plasma display panel and reducing external reflective light, or an anti-glare layer. It will be understood that the non-reflective layer 220 may use a thin-film layer made of a mixture capable of simultaneously performing an anti-reflection function and an anti-glare function.

The adhesive layer 230 may use acrylic base, rubber base, polyvinyl ether base, and silicon base, and the like.

FIGs. 2a to 2d are views for sequentially illustrating processes for manufacturing a front filter of the plasma display apparatus according to one embodiment.

Referring to FIG. 2a, the front panel 100 of the plasma display apparatus is prepared.

The front panel 100 is divided into a screen effective area A and a ground area B depending on whether the EMI shielding layer 130, which will be formed in a subsequent process, is exposed.

A plurality of pairs of maintenance electrodes 110A and 110B are prepared on a front substrate 110 of the screen effective area A to drive a plurality of pixels formed between the front panel 100 and a rear panel (not illustrated).

The maintenance electrode pairs 110A and 110B are formed of a transparent oxide electrode material such as indium-tin-oxide (ITO). Metal bus electrodes 112A and 112B are formed on the maintenance electrode pairs 110A and 110B to complement the conductivity of the maintenance electrode pairs 110A and 110B. A protective layer 120 made of MgO material is formed on the maintenance electrode pairs 110A and 110B.

The structures such as the maintenance electrode pairs 110A and 110B and the protective layer 120 are considered to be formed prior to manufacturing the front filter in embodiments which will be described below. However, the structures may be provided on a rear surface of the front panel 100 after manufacturing the front filter.

Referring to FIG. 2b, the EMI shielding layer 130 is formed on the opposite surface of the surface of the front substrate 110 on which the maintenance electrode pairs 110A and 110B are formed. The EMI shielding layer 130 is formed of a conductive material of a mesh type or a conductive type.

The mesh-type EMI shielding layer may be formed using a photolithography method, a printing method or a plating method. The photolithography method is that a copper foil is formed on a base film, and then a mesh-type pattern is obtained by performing exposure, developing, and etching processes on the copper foil. The printing method is that a copper paste is screen-printed on a base film, and then a mesh-type pattern is obtained through a dry process. The plating method is that a seed layer is formed on a base film, and then a desired pattern is obtained using an electroplating method.

The conductive-type EMI shielding layer is formed by repeatedly stacking Ag and ITO using a sputtering method.

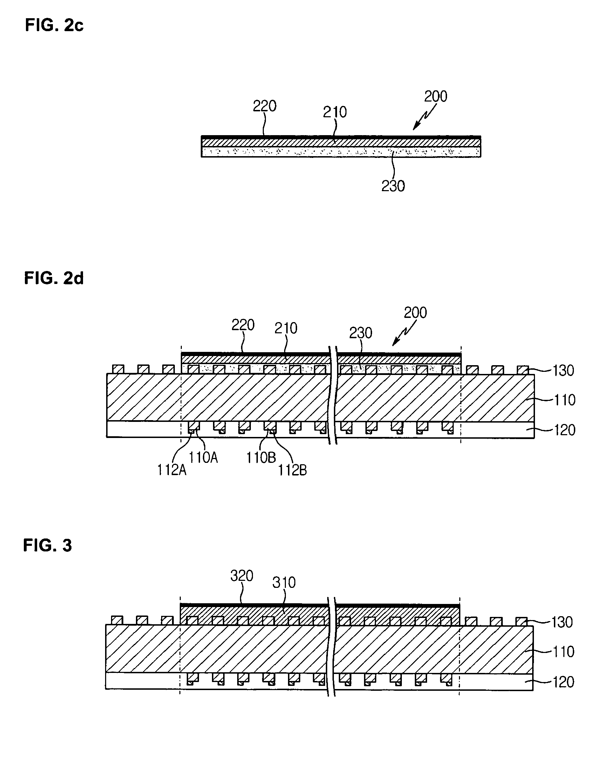

Referring to FIG. 2c, a filter 200 for protecting the EMI shielding layer 130 formed on the front panel 100 is manufactured separately from the front panel 100. The filter 200 may include a base film layer 210, and at least one type of non-reflective layer 220 formed on the base film layer 210.

An adhesive layer 230 is formed on the opposite surface to the surface of the base film layer 210 on which the non-reflective layer 220 is formed.

The adhesive layer 230 may further include a near infrared ray blocking material, and a selective light absorbing material for neon wavelength blocking and color correction. The selective light absorbing material may be obtained by mixing one or two or more of tetraazaporpin-based dye, cyanine-based dye, and squarylium-based dye, and the like.

Further, a film or a material for performing another function required may be interposed or added between the base film layer 210 and the non-reflective layer 220, between the EMI shielding layer 130 and the adhesive layer 230, or inside the adhesive layer 230.

For example, a near infrared ray blocking film including a near infrared ray blocking material may be added to the filter 200, or the near infrared ray blocking material may be added to the adhesive layer 230. The near infrared ray blocking material does not damage transparency and has a good near infrared ray blocking performance (for example, a near infrared ray absorbing performance in a near infrared ray wavelength of 800-1200 nm). The near infrared ray blocking material may use a mixing dye of nikel complex-based dye, phthalocyanine-based dye, naphthalocyanine-based dye, cyanine-based dye, diimmonium-based dye, and the like.

Referring to FIG. 2d, the filter 200 thus manufactured is adhered to the EMI shielding layer 130 of the front substrate 110. More specifically, the filter 200 is provided on the front substrate 110 so that the adhesive layer 230 comes in contact with the formation surface of the EMI shielding layer 130, thereby adhering the filter 200 to the EMI shielding layer 130 of the front substrate 110 using a pressure device such as a roll.

The filter 200 covers a portion of the EMI shielding layer 130 of the front substrate 110 (i.e., only the screen effective area A), and the ground area B is exposed to the outside.

After the filter 200 is previously cut up to adjust the size of the screen effective area A, the filter 200 may cover the screen effective area A by adhering the filter 200 to the front panel 100. Furthermore, after the filter 200 is adhered to the front panel 100 to cover the whole of the front panel 100, a portion of the filter 200 corresponding to the ground area B may be removed using a cutting device.

As above, while the related art film filter is adhered to the front glass, the EMI shielding layer 130 according to one embodiment is directly formed on the front panel 100.

Accordingly, in the plasma display apparatus according to one embodiment, the filter 200 and the EMI shielding layer 130 are separated from each other such that the EMI shielding layer 130 is not damaged when cutting the filter 200.

FIG. 3 illustrates a plasma display apparatus according to another embodiment.

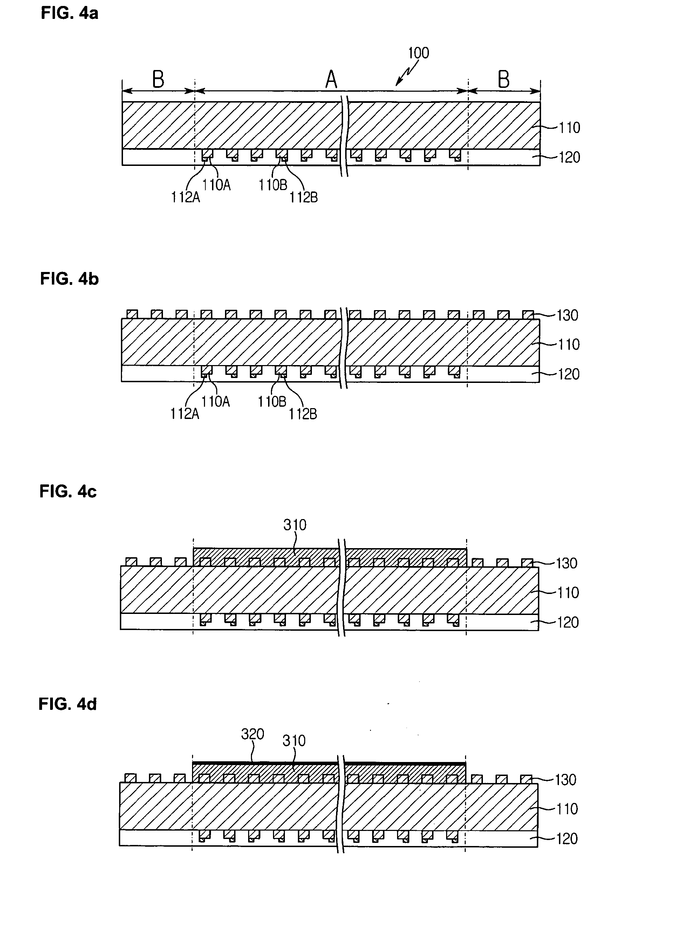

As illustrated in FIG. 3, the plasma display apparatus according to another embodiment includes a front panel 100 (refer to FIG. 4a) of a plasma display panel, an EMI shielding layer 130, a resin layer 310, and a non-effective layer 320.

Structures and components identical or equivalent to those described in the embodiments are designated with the same reference numerals, and the description thereabout is briefly made or is entirely omitted.

The resin layer 310 may be made of a transparent setting resin. For example, the resin layer 310 is obtained by applying thermosetting acrylic-based copolymer and a paste composition including a hardener. The paste composition may further include a viscosity control agent or a flowability control agent for flatting the surface.

FIGs. 4a to 4d are views for sequentially illustrating processes for manufacturing a front filter of the plasma display apparatus according to another embodiment.

FIGs. 4a and 4b illustrate processes for forming the EMI shielding layer 130 on a rear surface of the front substrate 110. Since the processes illustrated in FIGs. 4a and 4b is substantially equal to the processes illustrated in FIGs. 2a and 2b, a description thereof is omitted.

As illustrated in FIG. 4c, the resin layer 310 is formed on a portion of the front substrate 110, i.e., a screen effective area A. The resin layer 310 covers the EMI shielding layer 130 of the screen effective area A to protect the EMI shielding layer 130.

The paste composition may be applied using various methods. For example, a roll applying method, a spray applying method, or a screen printing method may be used.

A mask layer (not illustrated) may be provided on a ground area B of the front substrate 110 during the application of the paste composition to prevent the application of the paste composition to the ground area B. The mask layer may use an adhesive tape, and the like.

Dry and hardening processes are performed on the applied paste composition to form the resin layer 310. The used mask layer is then removed.

If necessary, the paste composition may include another composition for performing various functions of the filter after hardening the paste composition. For example, the paste composition may include a composition capable of performing a near infrared ray blocking function, a neon wavelength blocking function, or a color correction function.

In various kinds of compositions may be added to the paste composition. For example, in a case where the EMI shielding layer 130 is a conductive-type layer, a conductive layer performs a near infrared ray blocking function. Therfore, it is not necessary to add a composition for performing the near infrared ray blocking function to the paste composition.

As above, since the resin layer 310 is applied in a paste form in the plasma display apparatus according to another embodiment, the filter having various functions is formed by adding functional mixtures to the paste composition.

Referring to FIG. 4d, the non-effective layer 320 is additionally coated on the surface of the resin layer 310 through a dry or wet process. The non-effective layer 320 may include an anti-reflection layer or an anti-glare layer.

As described above, the plasma display apparatus according to at least certain embodiments has an inexpensive front filter including the EMI shielding layer. Further, it is easy to expose the ground area of the EMI shielding layer.

The foregoing embodiments and advantages are merely exemplary and are not to be construed as limiting the present invention. The present teaching can be readily applied to other types of apparatuses. The description of the foregoing embodiments is intended to be illustrative, and not to limit the scope of the claims. Many alternatives, modifications, and variations will be apparent to those skilled in the art.

## Claims

1. A plasma display apparatus comprising:
a plasma display panel;
an electromagnetic interference (EMI) shielding layer positioned on the plasma display panel; and
a filter positioned on the EMI shielding layer, the filter including an adhesive layer positioned on the EMI shielding layer and a base film layer positioned on the adhesive layer.

2. The plasma display apparatus of claim 1, wherein the EMI shielding layer includes a mesh type or a conductive type.

3. The plasma display apparatus of claim 1, wherein the filter is formed in an area except a ground portion of the EMI shielding layer.

4. The plasma display apparatus of claim 1, wherein the adhesive layer comprises at least one of a near infrared ray blocking material, a neon wavelength blocking material, or a selective light absorbing material.

5. The plasma display apparatus of claim 1, wherein the filter further comprises a non-reflective layer positioned on the base film layer.

6. A plasma display apparatus comprising:
a plasma display panel;
an electromagnetic interference (EMI) shielding layer positioned on the plasma display panel; and
a resin layer positioned on the EMI shielding layer.

7. The plasma display apparatus of claim 6, further comprising a non-reflective layer positioned on the resin layer.

8. The plasma display apparatus of claim 6, wherein the EMI shielding layer includes a mesh type or a conductive type.

9. The plasma display apparatus of claim 6, wherein the resin layer includes a thermosetting resin layer.

10. The plasma display apparatus of claim 6, wherein the resin layer is formed in an area except a ground portion of the EMI shielding layer.

11. The plasma display apparatus of claim 6, wherein the resin layer comprises at least one of a near infrared ray blocking material, a neon wavelength blocking material, or a selective light absorbing material.

12. A method of manufacturing a plasma display apparatus comprising:
forming an electromagnetic interference (EMI) shielding layer on a plasma display panel; and
forming a resin layer on the EMI shielding layer.

13. The method of claim 12, further comprising forming a non-reflective layer on the resin layer.

14. The method of claim 12, wherein forming the resin layer comprises
applying a resin paste including at least one of a near infrared ray blocking material, a neon wavelength blocking material, or a selective light absorbing material to an area except a ground portion of the EMI shielding layer, and
hardening the resin paste.

15. The method of claim 14, wherein applying the resin paste comprises masking an area corresponding to the ground portion of the EMI shielding layer.
